# EUROPEAN PATENT SPECIFICATION

(11) **EP 0 386 933 B1**
(45) Date of publication and mention of the grant of the patent: **17.08.1994**
(21) Application number: 90302151.7
(22) Date of filing: 28.02.1990
(51) Int. Cl.: H03F 3/217

(54) **Audio amplifier with phase modulated pulse width modulation**
Tonfrequenzverstärker mit phasenmodulierter Pulsbreitenmodulation
Amplificateur audio à modulation de largeur d'impulsion modulée en phase

(30) Priority: 04.03.1989 GB 8905002; 17.10.1989 US 422518
(43) Date of publication of application: 12.09.1990
(73) Proprietor: Peavey Electronics Corp., Meridian Mississippi 39301 (US)
(72) Inventor: Attwood, Brian E., Horsham, West Sussex (GB); Hand, Larry E., Meridan, Mississippi 39301 (US); Santillano, Lee C., Meridan, Mississippi 39307 (US)
(74) Representative: Dawson, Elizabeth Ann

(56) References cited:
- EP-A- 0 172 737
- GB-A- 1 157 888
- US-A- 3 956 716
- US-A- 4 479 175
- US-A- 4 573 018

## Description

### BACKGROUND OF THE INVENTION

This invention relates to digital switching systems in general and, more particularly, to an improved arrangement for providing a novel dc-to-dc converter as modified to provide an improved audio amplifier.

GB 1157888 gives a general description of the principles of phase modulation of a square wave according to an input signal. The specific application described in that document is in inverters used to generate a required alternating voltage using a dc power supply under the control of a control voltage. The described arrangement in GB 1157888 does not provide the features features necessary to obtain acceptable audio amplification.

A principal object of the present invention is to provide a digital controlled switching circuit which, in comparison with the prior art, has a lower component count, simpler manufacture, and further reduced weight and size, yet retains the performance required of a high-fidelity audio system.

The present invention is based on the use of phase modulated PWM rather than simple PWM.

For high-fidelity audio output, which is the principal field of the present invention, it is necessary to have low distortion, less than 0.25 THD and preferably less than 0.1 THD, and to achieve this the system should be capable of switching many times, preferably at least ten times, the highest audio frequency. It is also desirable that the amplifier be capable of stereo operation without an additional isolation transformer associated with the second audio channel.

The present invention provides a digital controlled switching circuit comprising:
a dc power source,
first switching means connected to said power source and operable to provide a square wave output,
second switching means having a forward conduction mode and connected to receive said square wave output,
phase control means responsive to an input signal and adapted to control the switching of said second switching means at a variable phase angle relative to the square wave output, the phase angle being a function of the magnitude of the input signal,
steering diode means for controlling the polarities of the outputs of said second switching means to operate in said forward conduction mode, whereby to provide a phase modulated pulse width modulated signal corresponding to said input signal, and
output filter means arranged to receive said phase modulated pulse width modulated signal and to output a corresponding analog time-averaged signal;
characterized in that said circuit is an audio amplifier in which said input signal is an input audio signal, which further comprises clamping means arranged to suppress voltage spikes in said phase modulated pulse width modulated signal output from said second switching means and means arranged to cause said second switching means to switch at a phase angle relative to said square wave of substantially 0° or 180° when said function of the input signal is less than 0° or greater than 180° respectively.

### BRIEF DESCRIPTION OF DRAWINGS

Figure 1 is a circuit diagram of an amplifier embodying the invention in a basic form;
Figure 2 shows waveforms illustrating phase modulation principles;
Figure 3 illustrates a modification of the amplifier of Figure 1;
Figure 4 illustrates a modification to another part of the amplifier of Figure 1;
Figure 5 illustrates an alternative modification to that of Figure 4;
Figure 6 illustrates an alternative modification to that of Figure 5;
Figure 7 is a view showing a modification of the audio input section; and
Figure 8 is a modification using a 90° phase shift.

### DESCRIPTION OF PREFERRED EMBODIMENTS

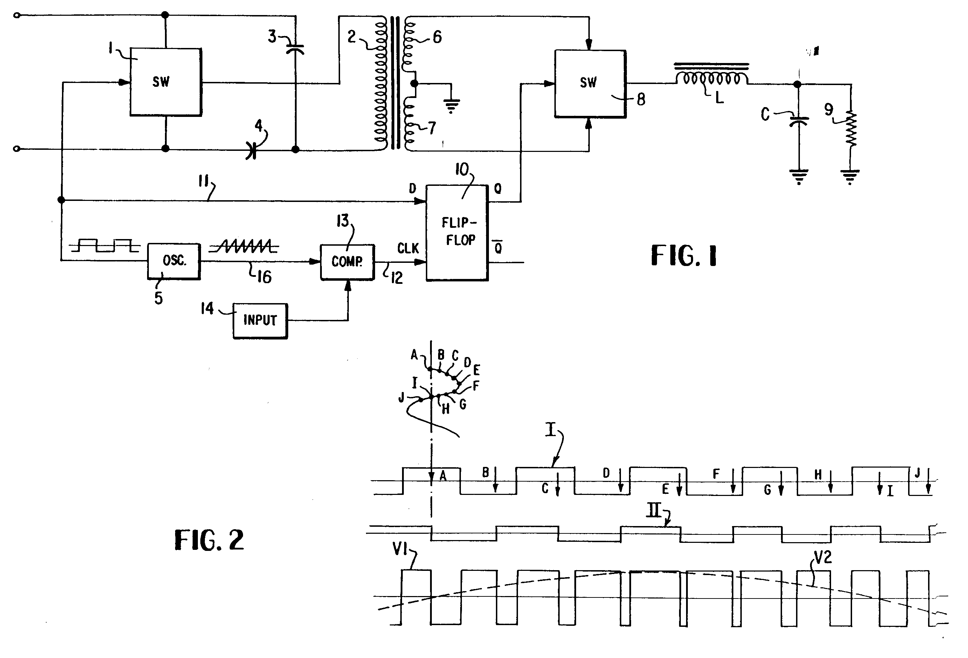

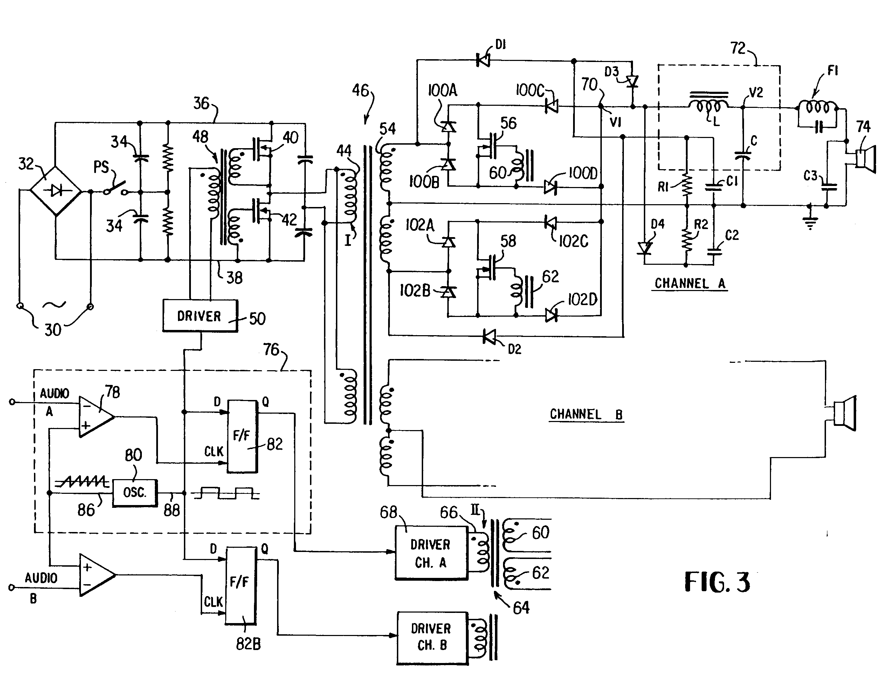

Referring to Figure 1, a somewhat simplified schematic which illustrative of certain principles of the invention will be seen. As will be more apparent when the invention is described in relation to Figure 3, it is necessary in practicing this invention that a dc power source be available.

In Figure 1, reference numeral 1 symbolically illustrates a first switching means connected to the illustrated dc power source and it will be understood that this switching means is effective alternately to cause conduction through the primary 2 of an isolator transformer as through the capacitor 3, and then in the opposite direction across the primary, as through the capacitor 4. The net result is that a reference square wave, indicated as numeral I in Figure 2, of equal mark/space ratio is imposed upon the transformer primary 2. This square wave is represented in Figure 2 at numeral I and is the reference square wave of the system and is controlled by the square wave output as illustrated for the oscillator means 5 of Figure 1. The secondaries 6 and 7 of the isolator transformer therefore have this reference square wave induced therein. However, the second switching means 8 alternately couples the induced square waves in phase modulated relationship through the output filter LC circuit and the load 9. The second switching means 8 is controlled by the logic means in the form of a D flip-flop 10 having as its D input the square wave reference signal from the oscillator means 5 as indicated at 11 and a clocking signal 12 from the comparator means 13. The comparator means receives a variable signal input from the means 14 and a sawtooth reference at 16 from the oscillator means 5. For ease of understanding, the waveforms of Figure 2 are identified at the appropriate points in Figure 1.

The means 8 contain circuitry involving toroid mechanism decoupling the circuitry from the secondaries 6 and 7 and serving to shift the phase of the reference signal induced across the secondaries 6 and 7 in the general fashion indicated in Figure 2 so that the signal V2 which is applied to the input means 14 controls the phase shift. Normally, the signals I and II would be 90° out of phase as is indicated for the points A and I so that their logic combination would be a zero output. However, the instantaneous amplitude (A, B, C, etc.) of the variable signal input controls the phase shift to produce the pulse width modulated signal VI which is recovered at the junction of L and C as the amplified input signal as represented by V2.

The principles of phase modulated pulse width modulation is used in the audio amplifier circuitry of Figure 3 wherein the ac input on the terminals 30 is rectified by the rectifier bridge 32 and smoothed by the capacitors 34 to provide dc across the lines 36, 38. The resistors in shunt across the capacitors 34 are needed to ensure equal voltage sharing.

The switch PS allows dual operation for 120/240 V systems, With the switch closed, the circuit operates as a voltage doubler providing approximately a 340 V dc bus across the Mosfets 40 and 42. With the switch open, for 240 V ac input, the dc bus will still be approximately 340 V dc, but not of course operating in the voltage doubler mode. The dc is switched by the Mosfets 40, 42 to provide the square wave reference signal which is of equal mark:space ratio to the primary 44 of the isolation transformer 46. The Mosfets 40, 42 are inductively coupled by a toroid 48 to a drive buffer 50 receiving the reference square wave from the oscillator means 80 which will be described in greater detail below. The amplifier of Figure 3 is a stereo amplifier with the channels A and B on the secondary power side. For simplicity only the channel A is shown in full; it will be apparent that channel B is similar.

Referring then to channel A, the essential elements are a center-tapped secondary 54 of the isolation transformer 46, the secondary outputs being switched by the Mosfets 56, 58 at a phase angle which is controlled with respect to the reference square wave. The Mosfets 56, 58 are controlled via the respective secondaries 60, 62 of a toroid 64 whose primary 66 is driven via the buffer amplifier 68 by a circuit 76 to be described. The outputs of the Mosfets 56, 58 are combined at 70 and applied via the low-pass filter network 72 to a load in the form of the loudspeaker 74.

Typical Mosfets 40 and 42 would be type IRF350 and the Mosfets 56 and 58 would be type IRF240.

The low pass LC filter 72 is designed to have a cutoff frequency higher than the audio band of 20 K Hz and will provide good rejection at the switching frequency and will ideally limit the open loop attenuation to less than 1 dB at 20 K Hz. Typical values for L and C are 33 uH and 0.47 uF.

The tuned circuit F1 is placed after the low pass filter 72 to provide further rejection at the switching frequency.

It will be noted that each of the secondary side switching Mosfets 56, 58 is connected via pairs of oppositely-poled steering diodes 100A-D, 102A-D. The steering diodes are required since both switches must operate bi-directionally. It might be thought that a possible alternative arrangement, as sometimes used for synchronous rectifier operation is to use pairs of back-to-back Mosfets on each side. This reduces the number of diodes required since Mosfets do have an intrinsic internal diode, but at the expense of increasing the number of Mosfets. With steering diodes, the single Mosfet operates only in its forward enhanced mode and the external diodes have much quicker turn-off, 25ns or so.

It will be noted that further diodes D1, D2, D3, D4 are required in order to clamp voltage spikes appearing across the transformer 46 and the low-pass filter 72. In the system described, no bus rails are available to clamp any overshoots via the diodes on the secondary and it is therefore necessary to provide an artificial rail by means of the diodes D1-D4 and suitable RC combinations. The transformer 46 should also have low leakage inductance to minimize overshoots.

Due to the absence of any solid dc bus rails on the secondary side of the transformer 46, overshoots due to stored energy in the inductor L can produce breakdown problems in addition to causing non-linearities in the audio waveform. Therefore, it is essential to clamp these overshoots and the method adopted is to use RC combinations R1, C1 and R2, C2 and diode clamp. The operation is that diodes D1, D2 and D3 will charge the capacitor C1 negatively to provide a floating dc bus rail, the value of R1 being chosen to dissipate the overshoot energy while holding the bus rail substantially constant.

The positive overshoots are clamped by the diode D4. Further clamping may be effected by additional diodes from the junction between the secondary 54 and the steering diode 100A to the junction between the diode D4 and the R2, C2 junction and the junction between the secondary 54 and the steering diode 102B to the junction between the diode D4 and the R2, C2 junction. In this latter case, the diode polarity will be for the cathode to be connected to R2, C2. They may be small diodes since they only have to handle the overshoot energy, not the main current path. Typical values for R1 would be 2K ohms, for C1 would be 10 pf and the diodes could be type HER103.

The steering diodes 100A, 100B, 100C and 100D are necessary to allow the bi-directional current flow necessary for an audio system. On the positive-going cycle of the transformer secondary 54, current will flow via the diode 100A into the Mosfet 56 and then through the diode 100D into the averaging inductor L and thence to the load.

On the negative cycles, the current flow will be via the averaging inductor L, the diode 100C, the Mosfet 56 and the diode 100B and the transformer secondary 54. Thus, the current can only flow when the polarity of the transformer and the diode combinations are correct, and the Mosfet 56 will only operate in its forward enhanced mode, the long reverse recovery internal diode not being activated.

The same process is of course applicable to the Mosfet 58 and the steering diodes 102A, 102B, 102C and 102D.

The control circuit 76 comprises a comparator 78, an oscillator 80 and a register 82. The audio input for channel A is applied to the inverting input of the comparator 78, which may suitably be a type LM311 integrated circuit. The audio input may be processed in known manner before being applied to the comparator, suitably via an input operational amplifier, a digital delay, a Bessel filter and a feedback op amp, with feedback from the low-pass filter output. For best distortion performance it is desirable to employ special feedback techniques as more fully described in the above-referenced US patent 4600891 and its Reissue.

The oscillator 80 produces the sawtooth waveform at 86, and a square wave of equal mark:space ratio at 88, the sawtooth being in phase with and at twice the frequency of the square wave. An integrated circuit suitable for this purpose is the US3825 high speed PWM controller by Unitrode Integrated Circuits of Merrimack, NH. The square wave output at 88 provides the reference signal to the primary driver 50.

For high quality audio applications, the PWM controller must have negligible deadtime between positive and negative excursions, certainly less than 100 ns. Most PWM controllers have deadtimes specifically built in to avoid crossover currents, the deadtime typically being 500 ns - 1 us. A very short or zero deadtime is essential for audio application (a) to avoid any distortion degradation of the audio component, which increases substantially if any deadtime is present between upper and lower Mosfet switching, and (b) any excessive deadtime would reduce modulation index and thus output power capability. In practice, it is preferred to reduce deadtime to about 10 ns at the output Mosfets with a switching frequency at the low pass filter of 250-500 kHz. Utilizing a fast controller such as the UC3825 and combining this with suitable lead and lag circuits in the drive circuitry, it is feasible to ensure that the output Mosfets do indeed switch within 10 ns or so for optimum performance.

The ramp signal at 86 acts as an audio sampling signal at the comparator 78, the comparator output switching when the ramp signal reaches a value equal to the instantaneous audio amplitude. The comparator output is then applied to the register 82. Preferably, the register 82 is a D-type flip-flop (suitably a type 7474 integrated circuit), the reference square wave being applied to the D input and the comparator output to the Clock input. The Q output of the flip-flop 82 is thus correctly positioned in phase to drive the Mosfets 56, 58 in the manner described above.

Channel B is controlled in exactly the same manner. The same oscillator 80 is used to time both channels. A 7474 circuit can act as a register for both channels, although a separate register is shown at 82B in Figure 1.

The low pass LC filter 72 is designed to have a cutoff frequency higher than the audio band of 20 K Hz and will provide good rejection at the switching frequency and will ideally limit the open loop attenuation to less than 1 dB at 20 K Hz. Typical values for L and C are 33 uH and 0.47 uF. The low-pass filtering technique used has been part of that fully described in the referenced patent 4,600,801 and its Reissue. The use of this prior technique however is not applicable to the high switching frequencies needed in the present invention (150-300 K Hz). This is because of the inherent limitations of the Mosfet internal diodes which are at least ten times slower than the Mosfet switching capability. Typical reverse recovery times of the internal diode range from 250 to 750 ns. The slow diodes also mean that a failure mode occurs particularly under spurious overload conditions. Under these conditions the switching waveforms are no longer synchronized and severe cross conduction can occur.

The drivers 50 and 68 may be type DS0026 integrated circuits or the like, or may be pnp/npn transistor complementary emitter followers.

There are a number of advantages to a phase modulated PWM audio amplifier. Firstly, the digital section of the amplifier (apart form the final input voltage to the low-pass filter) sees only square waves of approximately equal mark:space ratio. This allows the drive arrangements to be very simple, for example a small 60c toroid transformer driving switching devices in the form of Mosfets.

Secondly, the secondary power circuit no longer needs positive and negative dc bus rails. The power requirements are derived directly form the switching waveform from the isolation transformer, with no separate rectification for dc being required.

Further, for a given frequency of PWM signal into the filter, the power switching section can operate at half the frequency. For example, with 250 kHz power switching, the input to the low-pass filter becomes 500 kHz. This allows switching losses in the Mosfet section to be reduced, or alternatively the filter can be smaller for a given Mosfet loss.

The foregoing arrangement works well so long as the input amplitude does not exceed the amplitude of the sampling (ramp) signal. When this occurs, the modulator ceases to function, and the control signal to the secondary side Mosfets reduces to a dc level instead of a phase modulated signal. This problem could be met by limiting the amplitude of the input signal, but the resulting signal degradation may not be acceptable. Another approach is to add a pedestal to the top and bottom of the sampling signal; this has been found to be capable of satisfactory implementation, but involves more complexity.

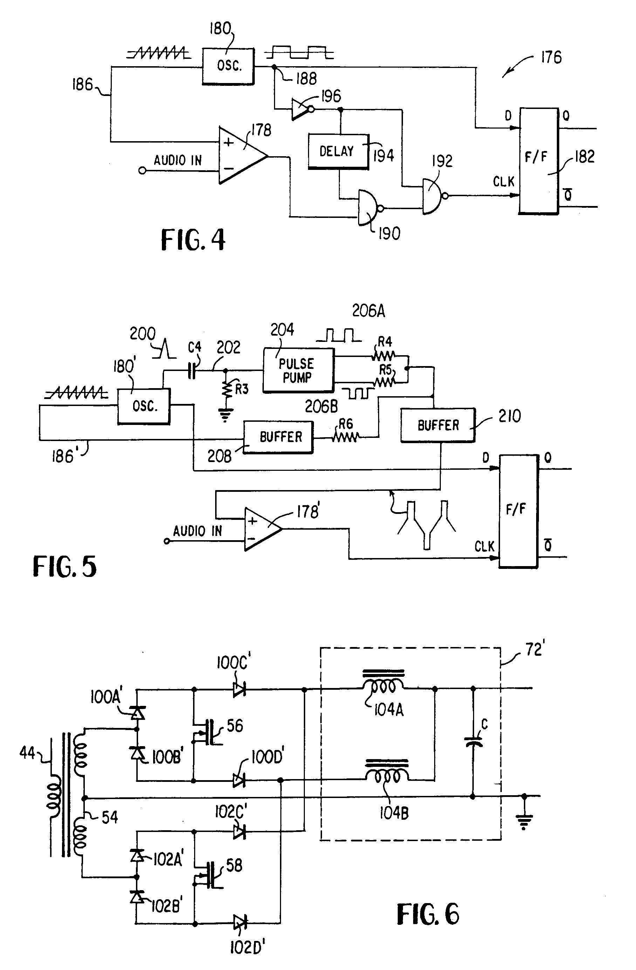

Figure 4 shows a control circuit 176 which can be substituted for the control circuit 76 of Figure 3 to meet the foregoing problem. The circuit of Figure 4 provides a digital limiting by inserting a clock transition at the peaks of the sampling ramp waveform.

As before, the oscillator 180 supplies a reference square wave signal at 188 and a sawtooth or ramp sampling signal at 186. The sampling signal is applied to the non-inverting input of the comparator 178, and the audio input to the inverting input.

In normal operation, the output of the comparator 178 changes state in each cycle of the sampling waveform. This output passes via the gates 190, 192 to the Clock input of the D-type flip-flop 182, and the circuit operates as described above. When, however, the input exceeds the peak value of the sampling signal, the transitions at the output of the comparator 178 stop, which can happen in either of two states. If the output stops in the zero state, then the input is greater than the maximum positive peak of the sampling signal and the output phase must be limited to just less than 180 degrees. To accomplish this, the phase reference signal at 188 is gated through the gate 192 to provide a Clock input to the register 182 synchronized with the peak of the sampling signal. If the output of the comparator 178 stops at the logic 1 state, then the input is more negative than the negative peak of the sampling signal and the output phase must be limited to just greater than zero degrees. To accomplish this, the reference pulse at 188 is delayed by a delay circuit 194 and then applied to the gate 190. Since the output of the comparator 178 is held high, the delayed reference pulse is fed through the gate 190 to the gate 192. The reference pulse and the delayed reference pulse combine at the gate 192 to give an output in the form of a narrow pulse on the trailing edge of the reference pulse, this narrow pulse being applied to the Clock input of the register 182 in the correct position to hold the output phase at just greater than zero degrees.

A buffer 196 is included to correct the polarity of the reference pulse and to buffer the signal. This buffer may not be necessary in all application.

Figure 5 shows an analog solution to the overdrive condition in which, as mentioned above, a pedestal is used at the top and bottom of the ramp waveform. A pulse 200 derived from the ramp retrace of the oscillator 180′ is differentiated at 202 and applied to a high speed buffer inverter amplifier 204 to provide positive and negative going pulses 206A, 206B which are combined with the ramp signal 186′, passing via the buffer 208, in an emitter follower circuit 210 to provide a combined signal 212 with pedestals to be applied to the non-inverting input of the comparator 178′. The positive and negative pedestals should preferably be about 5% of the total duty cycle so as to avoid undue limitation of the available modulation index. Also, the analog input signal applied to the comparator 178′ should be limited to such a level that it will not exceed the pedestal height. To achieve this the pedestal amplitude should exceed the ramp amplitude by at least 2:1.

The digital approach of Figure 4 for ramp clamping is preferred as being simpler and more precise.

It will be noted that each of the secondary side switching Mosfets 56, 58 is connected via pairs of oppositely-poled steering diodes 100A-D, 102A-D. The steering diodes are required since both switches must operate bi-directionally. It might be thought that a possible alternative arrangement, as sometimes used for synchronous rectifier operation is to use pairs of back-to-back Mosfets on each side. This reduces the number of diodes required since Mosfets do have an intrinsic internal diode, but at the expense of increasing the number of Mosfets. Under these conditions, the switching waveforms will no longer be synchronized and severe cross conduction may occur because of the turn-off time of the internal diodes, 250ns or longer. With steering diodes, the single Mosfet operates only in its forward enhanced mode and the external diodes have much quicker turn-off, 25ns or so.

Figure 6 shows a further modification in which the steering diodes 100D′ and 102D′ are separated from the steering diodes 100C′ and 102C′, the low-pass filter 72′ then being split into the inductors 104A, 104B. This is an alternative approach to avoid the problem brought about by using a typical PWM IC. These ICs usually have a dead zone between switching transitions for safety reasons. However, in the application under consideration, the use of a dead zone will give rise to unwanted and dangerous voltage spikes mainly due to energy stored in the low pass filter. The use of a split filter 104A, 104B will overcome this problem since by restructuring the control circuit to actually allow some small cross conduction between Mosfets 56 and 58, excessive cross conduction currents will be limited to a safe value while still producing some measure of damping to voltage spikes.

As shown in Figure 3, the invention makes is possible to drive two stereo channels from a single isolation transformer and primary reference oscillator, thus greatly reducing cost and size. To minimize cross-modulation each primary winding should be tightly coupled to its own secondary, with loose coupling to the other primary/secondary pair. In this way each secondary looks back directly at the very low source impedance of the primary Mosfets. Cross-modulation is also minimized by avoiding overshoots, as discussed above.

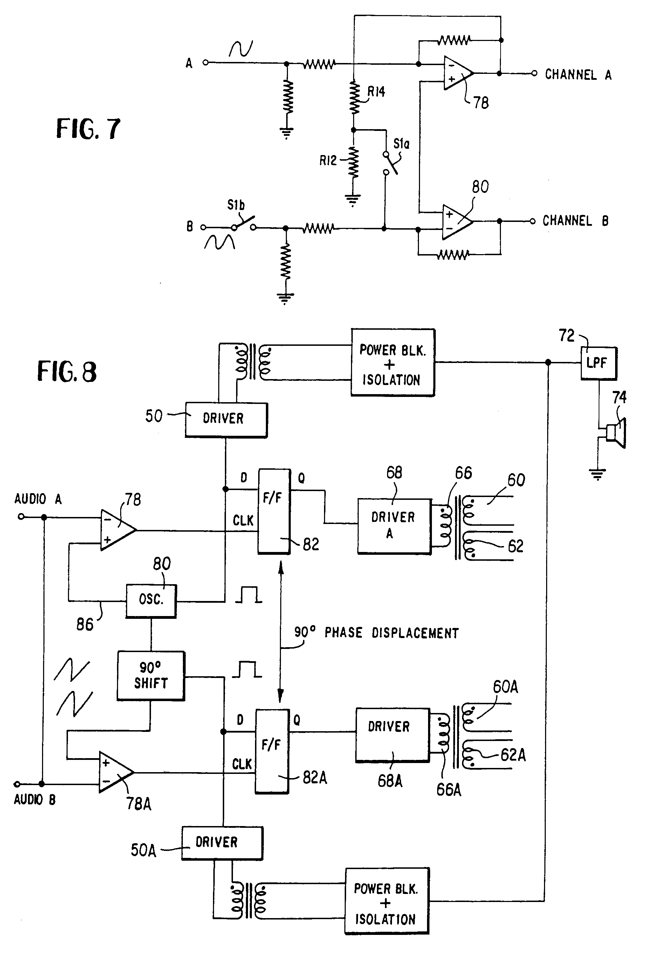

In the modification as in Fig. 7, a switchable phase reversal circuit is provided in series with one of the analog input channels A or B. This allows the amplifier to be used (a) as a stereo amplifier in unbridged mode, (b) by utilizing the phase reversal switches S1a and S2b in Fig. 7 (when S1a is open, S1b is closed and vice versa) and applying an out of phase signal to input B of the system it may be used as a high power mono amplifier in bridge mode, or (c) as a high power inverter for 50/60/400 Hz output giving 120 Vac in unbridged mode or 240 Vac in bridge mode. When used in bridge mode the outputs are taken between the two output channels. The ratio of the values of the resistors R11 and R12 is such as to give unity gain compared to input A.

In Fig. 8, another modification is to duplicate the primary Mosfets 40 and 42 and the driver 50 therefor as the driver 50A, the isolation transformer 44 and secondary circuit or power block which feeds the low pass filter 72, with the duplicate circuitry being driven at 90 degrees phase displacement by the comparator 78A, register 82a and driver 50a, and feeding the same low pass filter 72. The effective switching frequency becomes four times the primary switching frequency at the low pass filter junction 70.

## Claims

1. A digital controlled switching circuit comprising:
a dc power source,
first switching means (40,42) connected to said power source and operable to provide a square wave output,
second switching means (56,58) having a forward conduction mode and connected to receive said square wave output,
phase control means (76) responsive to an input signal and adapted to control the switching of said second switching means (56,58) at a variable phase angle relative to the square wave output, the phase angle being a function of the magnitude of the input signal,
steering diode means (100A-100D, 102A-102D) for controlling the polarities of the outputs of said second switching means to operate in said forward conduction mode, whereby to provide a phase modulated pulse width modulated signal (V1) corresponding to said input signal, and
output filter means (72) arranged to receive said phase modulated pulse width modulated signal and to output a corresponding analog time-averaged signal;
characterized in that said circuit is an audio amplifier in which said input signal is an input audio signal, which further comprises clamping means (D1-D4) arranged to suppress voltage spikes in said phase modulated pulse width modulated signal output from said second switching means and means (176) arranged to cause said second switching means to switch at a phase angle relative to said square wave of substantially 0° or 180° when said function of the input signal is less than 0° or greater than 180° respectively.

2. A digital controlled switching circuit in accordance with claim 1 in which said square wave output has an equal mark:space ratio, and said phase angle varies between 0 degrees and 180 degrees in accordance with the amplitude of the input signal whereby the output of said second switching means is a pulse-width-modulated representation of the control signal.

3. A digital controlled switching circuit according to claim 1 or 2 in which the first switching means is connected to the second switching means via a transformer (46).

4. A digital controlled switching circuit according to claim 3 in which the first switching means is connected to a primary winding of the transformer and the second switching means are connected to secondary windings of the transformer and in which said clamping means for suppressing voltage spikes comprises clamping diode means (D1, D2, D3, D4) connecting opposite sides of said secondary winding to ground and including parallel RC combinations in the ground connection.

5. A digital controlled switching circuit according to any preceding claim in which the phase control means comprises oscillator means (80) producing a square wave reference signal and a ramp signal synchronized therewith, means (50,48) connecting the square wave reference signal to the first switching means(40,42), a comparator (78) receiving an input from said audio signal input means and the ramp signal to produce a comparator output signal transition whose phase relative to the ramp signal is a function of the audio signal amplitude.

6. A digital controlled switching circuit according to claim 5 in which the comparator output signal is applied to a D-type flip-flop (82).

7. A digital controlled switching circuit according to claim 6 wherein the comparator output is applied to the clock input of the flip-flop and the square wave reference signal to the D input of the flip-flop.

8. A digital controlled switching circuit according to claim 7 in which the phase control means includes limit means for clocking the flip-flop (182) at 0 degrees or 180 degrees when the audio input is beyond the limits of the ramp signal.

9. A digital controlled switching circuit according to claim 8 in which said limit means comprises a delay circuit (194) having its input connected to receive the square wave reference signal, and gate means (192) connected to receive the comparator output and the delayed and undelayed square wave reference signals and having an output connected to the flip-flop clock input, the gate means being arranged such that when the comparator output is continuously in one state the flip-flop is clocked by the undelayed square wave reference signal, and when the comparator is continuously in the other state the flip-flop is clocked by a gated combination of the delayed and undelayed signals.

10. A digital controlled switching circuit as defined in claim 8 in which said limit means includes means (204, 208, 210) for adding pedestals to said ramp waveform.

11. A digital controlled switching circuit according to claim 1 wherein:
said first switching means comprises first and second Mosfets (40,42) connected in series across said dc power source, and reference signal means (80) applying a square wave reference signal (88) of equal mark:space ratio to said first and second Mosfets to cause them to conduct alternatively;
the circuit further comprising an isolating transformer (46) having a primary winding (44) driven by said first and second Mosfets and having at least one pair of center-tapped secondary windings (54), each of said secondary windings having respective Mosfet switching circuits (56,58) connected across it, said Mosfet switching circuits comprising said second switching means;
the steering diode means being connected across said Mosfet switching circuits;
the phase control means (76) comprising an oscillator (80) producing a ramp waveform in synchronization with said square wave reference signal, and a comparator (78) receiving as inputs said ramp waveform and the input signal, that signal being an input audio signal to be amplified; and
the output of the comparator (78) controlling said Mosfet switching circuits (56,58) to conduct at a phase angle with respect to said square wave reference signal which is a function of the input audio signal amplitude;
wherein said low-pass filter (72) is connected across said secondary windings to give a filtered output which is substantially an amplified version of the audio input signal.

12. A digital controlled switching circuit according to claim 1 comprising:
reference signal means (80) for applying a square wave reference signal to said first switching means (40,42); and
an isolating transformer (46) having a primary winding (44) driven by said first switching means and having a pair of center-tapped secondary windings (54);
wherein the second switching means (56,58) are connected across said secondary windings whereby to receive the square wave output from the first switching means;
wherein the phase control means (76) controls said second switching means (56,58) to conduct at a phase angle with respect to said square wave reference signal which is a function of the amplitude of said input signal;
the low-pass filter means (72) being connected across said secondary windings to give a filtered output which is an amplification of the input signal; and
wherein said clamping means for suppressing voltge spikes comprises clamping diode means (D1, D2, D3, D4) connecting opposite sides of said secondary winding to ground and including parallel RC combinations in the ground connection.

13. A digital controlled switching circuit according to claim 1 wherein the first switching means (40,42) are arranged to produce a reference square wave signal across a secondary winding (54);
the second switching means comprise bidirectional current switching means (56,58) connected across opposite sides of said secondary winding;
the clamping means for suppressing voltage spikes comprises clamping diode means (D1, D2, D3, D4) connecting opposite sides of said secondary winding to ground and including parallel RC combinations in the ground connection for creating artificial dc bus rails; wherein the phase control means (76) controls said current switching means (56, 58), the phase control means comprising an oscillator (80) producing a ramp waveform in synchronization with but at twice the frequency of said reference signal, comparator means (78) receiving as inputs said ramp waveform and an input signal to be amplified and a register means (82); and
the steering diode means (100A, 100B, 100C, 100D) are connected to said opposite sides of said current switching means (56,58).

14. A digital controlled switching circuit as defined in claim 13 including low pass filter means comprising split inductors (104A, 104B).

15. A digital controlled switching circuit as defined in claim 13 including means for shifting the phase of the signal to the register means.

16. A digital controlled switching circuit as defined in claim 13 including means for selectively reversing the phase of the input signal.

17. A digital controlled switching circuit as defined in claim 13, said current switching means comprising Mosfets.

18. A digital controlled switching circuit as defined in claim 5 wherein said comparator (78) has stereo channel inputs.

19. A digital controlled switching circuit as defined in claim 18 including separate channel driver means controlled by said register means (82).

20. A digital controlled switching circuit as defined in claim 19 including toroid means (60,62) driven by said driver means and controlling said second switching means (56,58).

## Patentansprüche

1. Digital gesteuerter Schaltungskreis umfassend:
eine Gleichstromquelle,
eine erste Schalteinrichtung (40, 42), verbunden mit der Stromquelle, und betriebsfähig, um einen Rechteckwellenausgang zu liefern,
eine zweite Schalteinrichtung (56, 58) mit einem Vorwärts-übertragungsmodus und geschaltet, um den Rechteckwellenausgang zu empfangen,
eine Phasensteuereinrichtung (76), ansprechend auf ein Eingangssignal und adaptiert, um das Schalten der zweiten Schalteinrichtung (56, 58) mit einem variablen Phasenwinkel in bezug auf den Rechteckwellenausgang Zu steuern, wobei der Phasenwinkel eine Funktion der Größe des Eingangssignals ist,
eine Steuerdiodeneinrichtung (100A-100D, 102A-102D) zum Steuern der Polaritäten der Ausgänge der zweiten Schalteinrichtung, um in dem Vorwärts-Übertragungsmodus zu arbeiten, um dadurch ein phasenmoduliertes pulsbreitenmoduliertes Signal (VI) zu liefern, das dem Eingangssignal entspricht, und
eine Ausgangsfiltereinrichtung (72), eingerichtet, um das phasenmodulierte pulsbreitenmodulierte Signal zu empfangen und um ein entsprechendes, analoges zeitgemitteltes Signal auszugeben;
dadurch gekennzeichnet, daß der Kreis ein Audioverstäker ist, bei dem das Eingangssignal ein Audioeingangssignal ist, der weiter eine Klemmeinrichtung (D1-D4), die eingerichtet ist, um Spannungsspitzen in dem phasenmodulierten pulsbreitenmodulierten Signal von der zweiten Schalteinrichtung zu unterdrücken, und eine Einrichtung (176) umfaßt, die eingerichtet ist, um die zweite Schalteinrichtug zu veranlassen, bei einem Phasenwinkel in bezug auf die Rechteckwelle von im wesentlichen 0° oder 180° zu schalten, wenn die Funktion des Eingangssignals kleiner als 0° bzw. größer als 180° ist.

2. Digital gesteuerter Schaltungskreis nach Anspruch 1, bei dem der Rechteckwellenausgang ein gleiches Zeichen/Pauseverhältnis hat und der Phasenwinkel gemäß der Amplitude des Eingangssignals zwischen 0 Grad und 180 Grad variiert, wodurch der Ausgang der zweiten Schalteinrichtung eine pulsbreitenmodulierte Darstellung des Eingangssignals ist.

3. Digital gesteuerter Schaltungskreis nach Anspruch 1 oder 2, bei dem die erste Schalteinrichtung über einen Transformator (46) mit der zweiten Schalteinrichtung verbunden ist.

4. Digital gesteuerter Schaltungskreis nach Anspruch 3, bei dem die erste Schalteinrichtung mit einer Primärwicklung des Transformators verbunden ist und die zweite Schalteinrichtung mit Sekundärwicklungen des Transformators verbunden ist, und bei dem die Klemmeinrichtung zum Unterdrücken der Spannungsspitzen eine Klemmdiodeneinrichtung (D1, D2, D3, D4) umfaßt, die entgegengesetzte Seiten der Sekundärwicklung mit Masse verbindet, und in der Masseverbindung parallele RC-Kombinationen enthält.

5. Digital gesteuerter Schaltungskreis nach einem der vorangehenden Ansprüche, bei dem die Phasensteuereinrichtung eine Oszillatoreinrichtung (80), die ein Rechteckwellen-Referenzsignal und ein damit synchronisiertes Rampensignal erzeugt, eine Einrichtung (50, 48), die das Rechteckwellen-Referenzsignal mit der ersten Schalteinrichtung (40, 42) verbindet, und einen Komparator (78) umfaßt, der einen Eingang von der Audiosignal-Eingangseinrichtung und das Rampensignal empfängt, um einen Komparator-Ausgangssignalübergang zu erzeugen, dessen Phase in bezug auf das Rampensignal eine Funktion der Audiosignalamplitude ist.

6. Digital gesteuerter Schaltungskreis nach Anspruch 5, bei dem das Komparator-Ausgangssignal an ein D-Flip-Flop (82) angelegt wird.

7. Digital gesteuerter Schaltungskreis nach Anspruch 6, bei dem der Komparatorausgang an den Takteingang des Flip-Flops und das Rechteckwellen-Referenzsignal an den D-Eingang des Flip-Flops angelegt wird.

8. Digital gesteuerter Schaltungskreis nach Anspruch 7, bei dem die Phasensteuereinrichtung eine Begrenzungseinrichtung enthält, um das Flip-Flop (182) bei 0 Grad oder 180 Grad zu takten, wenn der Audioeingang jenseits der Grenzen des Rampensignals liegt.

9. Digital gesteuerter Schaltungskreis nach Anspruch 8, bei dem die Begrenzungseinrichtung eine Verzögerungsschaltung (194), deren Eingang geschaltet ist, um das Rechteckwellen-Referenzsignal zu empfangen, und eine Gattereinrichtung (192) umfaßt, die geschaltet ist, um den Komparatorausgang und die verzögerten und unverzögerten Rechteckwellen-Referenzsignale zu empfangen, und mit einem Ausgang, der mit dem Flip-Flop-Takteingang verbunden ist, wobei die Gattereinrichtung so eingerichtet ist, daß, wenn der Komparatorausgang sich andauernd in einem Zustand befindet, das Flip-Flop durch das unverzögerte Rechteckwellen-Referenzsignal getaktet wird, und wenn der Komparatorausgang sich andauernd in dem anderen Zustand befindet, das Flip-Flop durch eine torgesteuerte Kombination des verzögerten und unverzögerten Signals getaktet wird.

10. Digital gesteuerter Schaltungskreis nach Anspruch 8, bei dem die Begrenzungseinrichtung eine Einrichtung (204, 208, 210) einschließt, um der Rampenwellenform Sockel hinzuzufügen.

11. Digital gesteuerter Schaltungskreis nach Anspruch 1, worin:
die erste Schalteinrichtung einen ersten und zweiten Mosfet (40, 42), die in Serie über die Gleichstromquelle geschaltet sind, und eine Referenzsignaleinrichtung (80) umfaßt, die ein Rechteckwellen-Referenzsignal (88) mit gleichem Zeichen/Pauseverhältnis an den ersten und zweiten Mosfet anlegt, um sie zu veranlassen, abwechselnd zu leiten;
wobei der Kreis weiter einen Trenntransformator (46) mit einer durch den ersten und zweiten Mosfet getriebenen Primärwicklung (44) und mit wenigstens einem Paar mittelangezapfter Sekundärwicklungen (54) umfaßt, wobei jede der Sekundärwicklungen über sie geschaltete jeweilige Mosfet-Schaltkreise (56, 58) besitzt, wobei die Mosfet-Schaltkreise die zweite Schalteinrichtung umfassen;
wobei die Steuerdiodeneinrichtung über die Mosfet-Schaltkreise geschaltet ist;
wobei die Phasensteuereinrichtung (76) einen Oszillator (80), der eine Rampenwellenform in Synchronisation mit dem Rechteckwellen-Referenzsiganl erzeugt, und einen Komparator (78) umfaßt, der als Eingänge die Rampenwellenform und das Eingangssignal empfängt, wobei dieses Signal ein zu verstärkendes Eingangsaudiosignal ist; und
wobei der Ausgang des Komparators (78) die Mosfet-Schaltkreise (56, 58) steuert, um bei einem Phasenwinkel in bezug auf das Rechteckwellen-Referenzsignal zu leiten, der eine Funktion der Amplitude des Eingangsaudiosignals ist;
worin das Tiefpaßfilter (72) über die Sekundärwicklungen geschaltet ist, um einen gefilterten Ausgang zu übergeben, der im wesentlichen eine verstärkte Version des Audioeingangssignals ist.

12. Digital gesteuerter Schaltungskreis nach Anspruch 1, umfaasend:
eine Referenzsignaleinrichtung (80) zum Anlegen eines Rechteckwellen-Referenzsignals an die erste Schalteinrichtung (40, 42); und
einen Trenntransformator (46) mit einer durch die erste Schalteinrichtung getriebenen Primärwicklung (44) und mit einem Paar mittelangezapfter Sekundärwicklungen (54);
worin die zweite Schalteinrichtung (56, 58) über die Sekundärwicklungen geschaltet ist, um dadurch den Rechteckwellenausgang von der ersten Schalteinrichtung zu empfangen;
worin die Phasensteuereinrichtung (67) die zweite Schalteinrichtung (56, 58) steuert, um bei einem Phasenwinkel in bezug auf das Rechteckwellen-Referenzsignal zu leiten, der eine Funktion der Amplitude des Eingangssignals ist;
wobei die Tiefpaßfiltereinrichtung (72) über die Sekundärwicklungen geschaltet ist, um einen gefilterten Ausgang zu übergeben, der eine Verstärkung des Eingangssignals ist; und
worin die Klemmeinrichtung zum Unterdrücken der Spannungsspitzen eine Klemmdiodeneinrichtung (D1, D2, D3, D4) umfaßt, die entgegengesetzte Seiten der Sekundärwicklung mit Masse verbindet, und in der Masseverbindung parallele RC-Kombinationen enthält.

13. Digital gesteuerter Schaltungskreis nach Anspruch 1, worin die erste Schalteinrichtung (40, 42) eingerichtet ist, um ein Referenz-Rechteckwellensignal über einer Sekundärwicklung (54) zu erzeugen;
die zweite Schalteinrichtung eine bidirektionale Stromschalteinrichtung (56, 58) umfaßt, die über entgegengesetzte Seiten der Sekundärwicklung geschaltet ist;
die Klemmeinrichtung zum Unterdrücken der Spannungsspitzen eine Klemmdiodeneinrichtung (D1, D2, D3, D4) umfaßt, die entgegengesetzte Seiten der Sekundärwicklung mit Masse verbindet, und in der Masseverbindung parallele RC-Kombinationen enthält, um künstliche DC-Bus-Schienen zu erzeugen;
worin die Phasensteuereinrichtung (76) die Stromschalteinrichtung (56, 58) steuert, wobei die Phasensteuereinrichtung einen Oszillator (80), der eine Rampenwellenform in Synchronisation mit, aber bei dem Zweifachen der Frequenz des Referenzsignals erzeugt, wobei die Komparatoreinrichtung (78) als Eingänge die Rampenwellenform und ein zu verstärkendes Eingangssignal empfängt, und eine Registereinrichtung (82) umfaßt, und
die Steuerdiodeneinrichtung (100A, 100B, 100C, 100D) mit den entgegengesetzten Seiten der Stromschalteinrichtung (56, 58) verbunden ist.

14. Digital gesteuerter Schaltungskreis nach Anspruch 13, mit einer Tiefpaßfiltereinrichtung (72), die geteilte Spulen (104A, 104B) umfaßt.

15. Digital gesteuerter Schaltungskreis nach Anspruch 13, mit einer Einrichtung zum Verschieben der Phase des Signals an die Registereinrichtung.

16. Digital gesteuerter Schaltungskreis nach Anspruch 13, mit einer Einrichtung, um die Phase des Eingangssignals selektiv umzukehren.

17. Digital gesteuerter Schaltungskreis nach Anspruch 13, wobei die Stromschalteinrichtung Mosfets umfaßt.

18. Digital gesteuerter Schaltungskreis nach Anspruch 5, worin der Komparator (78) Stereokanaleingänge hat.

19. Digital gesteuerter Schaltungskreis nach Anspruch 18, mit einer durch die Registereinrichtung (82) gesteuerten getrennten Kanaltreibereinrichtung.

20. Digital gesteuerter Schaltungskreis nach Anspruch 19, mit einer Toroid-Einrichtung (60, 62), die von der Treibereinrichtung getrieben wird und die zweite Schalteinrichtung (56, 58) steuert.

## Revendications

1. Circuit de commutation commandé numérique comprenant :
une source d'alimentation courant continu ;
un premier moyen de commutation (40, 42) connecté à ladite source d'alimentation et fonctionnant pour produire une sortie d'onde carrée ;
un second moyen de commutation (56, 58) présentant un mode de conduction direct et étant connecté pour recevoir ladite sortie d'onde carrée ;
un moyen de commande de phase (76) sensible à un signal d'entrée et conçu pour commander la commutation dudit second moyen de commutation (56, 58) selon un angle de phase variable par rapport à la sortie d'onde carrée, l'angle de phase étant fonction de l'amplitude du signal d'entrée ;
un moyen de diodes de déclenchement (100A-100D, 102A-102D) pour commander les polarités des sorties dudit second moyen de commutation pour fonctionner dans ledit mode de conduction en sens direct afin d'ainsi produire un signal modulé en largeur d'impulsion modulée en phase (V1) correspondant audit signal d'entrée ; et
un moyen de filtre de sortie (72) agencé pour recevoir ledit signal modulé en largeur d'impulsion modulée en phase et pour émettre en sortie un signal moyenné temporellement analogique correspondant,
caractérisé en ce que ledit circuit est un amplificateur audio dans lequel ledit signal d'entrée est un signal audio d'entrée, lequel comprend en outre un moyen de verrouillage (D1-D4) agencé pour supprimer des pics de tension dans ledit signal modulé en largeur d'impulsion modulée en phase émis en sortie depuis ledit second moyen de commutation et un moyen (176) agencé pour forcer ledit second moyen de commutation à réaliser une commutation selon un angle de phase par rapport à ladite onde carrée de sensiblement 0° ou 180° lorsque ladite fonction du signal d'entrée est respectivement inférieure à 0° ou supérieure à 180°.

2. Circuit de commutation commandé numérique selon la revendication 1, dans lequel ladite sortie d'onde carrée présente un rapport cyclique égal et ledit angle de phase varie entre 0° et 180° en relation avec l'amplitude du signal d'entrée et ainsi, la sortie dudit second moyen de commutation est une représentation de modulation de largeur d'impulsion du signal de commande.

3. Circuit de commutation commandé numérique selon la revendication 1 ou 2, dans lequel le premier moyen de commutation est connecté au second moyen de commutation via un transformateur (46).

4. Circuit de commutation commandé numérique selon la revendication 3, dans lequel le premier moyen de commutation est connecté à un enroulement primaire du transformateur et le second moyen de commutation est connecté à des enroulements secondaires du transformateur et dans lequel ledit moyen de verrouillage pour supprimer les pics de tension comprend un moyen de diodes de verrouillage (D1, D2, D3, D4) qui connecte les côtés opposés dudit enroulement secondaire à la masse et qui inclut des combinaisons RC parallèles dans la connexion à la masse.

5. Circuit de commutation commandé numérique selon l'une quelconque des revendications précédentes, dans lequel le moyen de commande de phase comprend un moyen d'oscillateur (80) qui produit un signal de référence d'onde carrée et un signal en rampe synchronisé avec, un moyen (50, 48) qui connecte le signal de référence d'onde carrée au premier moyen de commutation (40, 42), un comparateur (78) qui reçoit une entrée provenant dudit moyen d'entrée de signal audio et le signal en rampe pour produire une transition de signal de sortie de comparateur dont une phase relative au signal en rampe est une fonction de l'amplitude du signal audio.

6. Circuit de commutation commandé numérique selon la revendication 5, dans lequel le signal de sortie de comparateur est appliqué à une bascule de type D (82).

7. Circuit de commutation commandé numérique selon la revendication 6, dans lequel la sortie du comparateur est appliquée sur l'entrée d'horloge de la bascule et le signal de référence d'onde carrée est appliqué sur l'entrée D de la bascule.

8. Circuit de commutation commandé numérique selon la revendication 7, dans lequel le moyen de commande de phase inclut un moyen de limitation pour cadencer la bascule (182) à 0 ou 180 degrés lorsque l'entrée audio est au-delà des limites du signal en rampe.

9. Circuit de commutation commandé numérique selon la revendication 8, dans lequel ledit moyen de limitation comprend un circuit de retard (194) dont l'entrée est connectée pour recevoir le signal de référence d'onde carrée, et un moyen de porte (192) connecté pour recevoir la sortie du comparateur et les signaux de référence d'onde carrée retardé et non retardé et dont une sortie est connectée à l'entrée d'horloge de la bascule, le moyen de porte étant agencé de telle sorte que lorsque la sortie du comparateur est en continu dans un premier état, la bascule soit cadencée par le signal de référence d'onde carrée non retardé et que lorsque le comparateur est en continu dans l'autre état, la bascule soit cadencée par une combinaison soumise à une logique de porte des signaux retardé et non retardé.

10. Circuit de commutation commandé numérique selon la revendication 8, dans lequel ledit moyen de limitation inclut un moyen (204, 208, 210) pour additionner des phases planes à ladite forme d'onde en rampe.

11. Circuit de commutation commandé numérique selon la revendication 1, dans lequel :
ledit premier moyen de commutation comprend des premier et second MOSFET (40, 42) connectés en série aux bornes de ladite source d'alimentation continue et un moyen de signal de référence (80) qui applique un signal de référence d'onde carrée (88) de rapport cyclique égal auxdits premier et second MOSFET pour les amener à devenir passants en alternance ;
le circuit comprenant en outre un transformateur d'isolation (46) comportant un enroulement primaire (44) piloté par lesdits premier et second MOSFET et comportant au moins une paire d'enroulements secondaires à connexion centrale (54), chacun desdits enroulements secondaires comportant des circuits de commutation de MOSFET respectifs (56, 58) connectés à ses bornes, lesdits circuits de commutation de MOSFET comprenant ledit second moyen de commutation ;
le moyen de diodes de déclenchement étant connecté aux bornes desdits circuits de commutation de MOSFET ;
le moyen de commande de phase (76) comprenant un oscillateur (80) produisant une forme d'onde en rampe en synchronisation avec ledit signal de référence d'onde carrée et un comparateur (78) recevant en tant qu'entrées ladite forme d'onde en rampe et le signal d'entrée, ce signal étant un signal audio d'entrée qui doit être amplifié ; et
la sortie du comparateur (78) commandant lesdits circuits de commutation de MOSFET (56, 58) pour qu'ils deviennent passants pour un angle de phase par rapport audit signal de référence d'onde carrée qui est une fonction de l'amplitude du signal audio d'entrée ;
dans lequel ledit filtre passe-bas (72) est connecté aux bornes desdits enroulements secondaires pour produire une sortie filtrée qui est significativement une version amplifiée du signal d'entrée audio.

12. Circuit de commutation commandé numérique selon la revendication 1, comprenant :
un moyen de signal de référence (80) pour appliquer un signal de référence d'onde carrée audit premier moyen de commutation (40, 42) ; et
un transformateur d'isolation (46) comportant un enroulement primaire (44) piloté par ledit premier moyen de commutation et comportant une paire d'enroulements secondaires à connexion centrale (54),
dans lequel le second moyen de commutation (56, 58) est connecté aux bornes desdits enroulements secondaires pour ainsi recevoir la sortie d'onde carrée provenant du premier moyen de commutation,
dans lequel le moyen de commande de phase (76) commande ledit second moyen de commutation (56, 58) de manière à ce qu'il soit passant pour un premier angle de phase par rapport audit signal de référence d'onde carrée qui est une fonction de l'amplitude dudit signal d'entrée ;
le moyen de filtre passe-bas (72) étant connecté aux bornes desdits enroulements secondaires pour produire une sortie filtrée qui est une amplification du signal d'entrée ; et
dans lequel ledit moyen de verrouillage pour supprimer les pics de tension comprend un moyen de diodes de verrouillage (D1, D2, D3, D4) qui connecte des côtés opposés dudit enroulement secondaire à la masse et qui inclut des combinaisons RC parallèles dans la connexion à la masse.

13. Circuit de commutation commandé numérique selon la revendication 1, dans lequel le premier moyen de commutation (40, 42) est agencé pour produire un signal d'onde carrée de référence aux bornes d'un enroulement secondaire (54) ;
le second moyen de commutation comprend un moyen de commutation de courant bidirectionnel (56, 58) connecté aux bornes de côtés opposés dudit enroulement secondaire ;
le moyen de verrouillage pour supprimer des pics de tension comprend un moyen de diodes de verrouillage (D1, D2, D3, D4) qui connecte des côtés opposés dudit enroulement secondaire à la masse et qui inclut des combinaisons RC parallèles dans la connexion à la masse pour créer des rails de bus courant continu artificiels ;
dans lequel le moyen de commande de phase (76) commande ledit moyen de commutation de courant (56, 58), le moyen de commande de phase comprenant un oscillateur (80) produisant une forme d'onde en rampe en synchronisation avec ledit signal de référence mais à deux fois la fréquence de celui-ci, un moyen de comparateur (78) qui reçoit en tant qu'entrées ladite forme d'onde en rampe et un signal d'entrée qui doit être amplifié et un moyen de registre (82) ; et
le moyen de diodes de déclenchement (100A, 100B, 100C 100D) est connecté auxdits côtés opposés dudit moyen de commutation de courant (56, 58).

14. Circuit de commutation commandé numérique selon la revendication 13, incluant un moyen de filtre passe-bas comprenant des inducteurs séparés (104A, 104B).

15. Circuit de commutation commandé numérique selon la revendication 13, incluant un moyen pour décaler la phase du signal sur le moyen de registre.

16. Circuit de commutation commandé numérique selon la revendication 13, incluant un moyen pour inverser sélectivement la phase du signal d'entrée.

17. Circuit de commutation commandé numérique selon la revendication 13, ledit moyen de commutation de courant comprenant des MOSFET.

18. Circuit de commutation commandé numérique selon la revendication 5, dans lequel ledit comparateur (78) comporte des entrées de canaux stéréo.

19. Circuit de commutation commandé numérique selon la revendication 18, incluant un moyen de pilotage de canaux séparés commandé par ledit moyen de registre (82).

20. Circuit de commutation commandé numérique selon la revendication 19, incluant un moyen toroïdal (60, 62) piloté par ledit moyen de pilotage et commandant ledit second moyen de commutation (56, 58).
